# EUROPEAN PATENT APPLICATION

(11) **EP 1 245 962 A1**
(43) Date of publication of application: **02.10.2002**
(21) Application number: 02252151.2
(22) Date of filing: 26.03.2002
(51) Int. Cl.: G01R 31/28

(54) **Improved connection interface system**

(30) Priority: 26.03.2001 GB 1074608
(71) Applicant: M.E.I.- Technologies Ltd, Bollington, Cheshire SK10 5JZ (GB)
(72) Inventor: Edwards, Barry Vincent, Macclesfield, Cheshire SK10 2PX (GB); Hurst, Roy Joseph, Congleton, Cheshire CW12 3RD (GB)
(74) Representative: Wilson Gunn M'Caw

(57) **Abstract**

A connection interface system for providing an interface between a unit under test and testing equipment, the system comprising a receiver 2 having a pair of channels 23,25, and a receiver connector module 12,14 having a pair of shoulders 30,32. In use the module 12,14 is releasably retained on the receiver 2 in a reverse mounted position by press-fitting the shoulder of the module 12,14 into the channels 23,25 of the receiver 2.

## Description

The present invention relates to an improved connection interface system for providing an interface between a unit under test (UUT) and testing equipment to facilitate automatic testing of the unit under test (UUT) by the testing equipment.

A connector interface system comprises two main parts, namely, a receiver and an interchangeable test adapter (ITA). The receiver and the ITA are each adapted to carry a plurality of connector modules. The connector modules provide holders into which contacts and cables of electrical wiring can be received, in the case of the receiver the contacts of the wiring which connects to the testing equipment and in the case of the ITA the contacts of the wiring which connects to the UUT. Mating of the contacts of the connector modules of the receiver and those of the ITA, connects the testing equipment to the UUT. In order to facilitate this mating the ITA has rollers which locate into latches on the receiver. A mechanical leverage system, housed within the receiver, connects these latches to a handle. When the handle is operated, this causes the ITA, guided by the location device, to be drawn accurately into the receiver, making the electrical contacts and then drawing it into place. Operating the handle in the opposite direction will break the electrical contacts and release the ITA ready for removal or re-engagement. This system of mating is described in Intellitest (Europe) Limited's UK Patent Application, published under the number GB 2 323 219.

In order to allow maximum flexibility in the lay out of electrical contacts, and thereby allow connection to a variety of testing equipment and UUT; a modular mounting system is generally employed for both the receiver and the ITA. By changing the type of connector modules attached to the frameworks of the receiver and the ITA, modules can be provided which allow a required style of connection for the UUT and the testing equipment. Therefore, the receiver and the ITA are generally adapted to receive a plurality of different connector modules, at a plurality of positions on their framework.

In a known interface system there is provided a receiver comprising a substantially rectangular frame which can be directly mounted to the housing of testing equipment, the housing providing a card case comprising a plurality of test cards mounted in rails therein. The frame work of the receiver has a pair of spaced apart, parallel mounting bars each of which have a plurality of screw receiving apertures. The receiver connector modules can be mounted between these bars by securing the module with screws to the bars. During the mating of the contacts held by the receiver connector modules and those held by the ITA connector modules, each contact experiences several grams of mating force. For the considerable number of contacts being made or broken during mating and breaking of the contacts, this can amount to in the order of half a ton of mating or breaking force at the interface.

The advantage of this known receiver is, that because the receiver connector modules are firmly secured to the receiver frame by screw fittings, some of this force is absorbed by the receiver thereby reducing the occurrence of potential damage to the contacts. However, the disadvantage is that when breaking the contacts the force absorbed by the receiver connector modules fixing is concentrated on the screw fitting, leading to potential damage of this fitting and thereby reduction in the life span of the receiver.

The receiver connector modules are removably fixed to the front of the receiver in order that when the receiver is fixed to the testing equipment, the module can be simply unscrewed and removed to allow access into the testing equipment. For this purpose it is necessary that the wiring leading from the receiver connector modules to the test cards, which are held within the testing equipment, is relatively long in order to allow the module to be lifted away without damaging the contacts at either the module or at the card. This has the disadvantage that, due to the large number of contacts a considerable mass of unruly wiring is present, which makes it difficult for an operator to access and therefore reconfigure the system.

In order to alleviate the above described drawback a receiver was developed by Virginia Panel Corporation (US 5 103 378) in which instead of mounting the receiver connector modules on the front of the receiver, these modules are instead located at the rear of the receiver. In this design each module is mounted on an adapter. The adapter provides an extension into the testing unit and the wires of the contacts held in the module are contained within the housing of the adapter. The end of the adapter, remote from the module, carries a further interface for connection to the test cards held within the testing unit.

This arrangement has the advantage that it keeps the wiring more ordered, and the adapter carrying the module is more readily demountable. In order for the contacts held in the receiver connector module to mate with those of the ITA connector module, the receiver and adapter carry respective co-acting alignment holes and alignment pins. In this respect a pair of fixed alignment pins are located on the adapter, one on either side of the connector module. The alignment holes on the receiver are provided as apertures in the mounting bars of the receiver. The connector module is positioned by the placement of the adapter pins into corresponding apertures in the mounting bars of the receiver, and the module is held in place by its fixing on the test card.

In order to allow removal of a connector module in order to access the testing equipment, the receiver is additionally modified to comprise a front and back panel frame sections which are permanently hinged together to allow the front panel to be pivoted away from the back panel, which back panel in use would be secured to the testing equipment. The front panel carries the latches to connect the ITA to the receiver and also the mounting bars. Because the pins of the receiver connector module is only located in and not held by the apertures on the mounting bars, when the front panel is hinged down, the receiver connector module is accessible to an operator who then simply removes the receiver connector module by disconnecting its fixing to the test card. Whilst this system allows easier access to the test cards, it has the disadvantage that when the contacts held by the receiver connector module and those of the ITA connector module are mated, the mating force on the receiver connector modules force the modules backwards into the testing equipment. Because the modules are not fixedly held in place by the receiver the mating force is transferred through the fixing of its adapter to the test card. This results in possible damage to the cards and/or their connections to the adapter and/orthe contacts held in the module which may buckle when the contacts held in the modules of the ITA are inserted.

A further disadvantage of this design of receiver for the connection interface system is that it is specially designed for testing equipment incorporating rail mounted test cards which provide a connection and mounting for the adapters together with sufficient internal space to accommodate the reverse located receiver connector modules with their integral adapter. It is not suitable for bench or rack and stack mounted test equipment, because the only fixing for the receiver connecter modules is to the test cards and it is not possible to mate the contacts held within the receiver/connector modules and those of the ITA without some form of fixing. Furthermore the adapters are specifically designed to only connect to the testing cards.

It is an object of the present invention to provide a connection interface system which overcomes or alleviates the above described drawbacks.

In accordance with one aspect of the present invention, there is provided a connection interface system comprising a receiver having retaining means to releasably retain a plurality of receiver connector modules thereon in a reverse mounted position.

By reverse mounting the modules, unlike the receiver in which the modules are front mounted modules, it is possible to mount modules which incorporate an adapter for connection to test cards of a card cage, and thereby reduce the amount of loose wiring present. Also by releasably retaining the modules on the receiver, the mating force when mating or breaking the contacts held by the receiver contact modules and those of the ITA are absorbed by the mounting on the receiver, and not transferred to the mounting of the adapter as per the system whereby the modules are merely reverse located with respect to the receiver. Also, because the modules are releasably retained on the receiver, it is possible to also mount modules which do not incorporate an adapter, making the present system suitable not only for mounting to a card cage, but also for bench and rack and stack type testing equipment.

The retaining means may comprise channels in the body of the receiver which in use receive the modules in a press-fit manner. This has the advantage of being a simple means of retaining the modules. Furthermore the channels absorb any mating or breaking force, thereby transferring this force to the receiver body. This has the advantage over modules retained by a screw fitting that the absorbed force is not directed through the screw mounting.

Preferably, the connection interface system further comprises at least one receiver connector module having mounting means for receipt in said channels. In a preferred embodiment the mounting means is a pair of shoulders which stand proud of the module.

Preferably the receiver has a pair of spaced mounting bars, adjacent each bar at the rear of the receiver is a respective mounting rail, one of said channels being formed between each mounting bar and said adjacent rail.

In a preferred embodiment the connection interface system further comprises at least one receiver connecting module having alignment means, the mounting rails having a plurality of slots and/or apertures into which said alignment means is received in order to fix the relative position of the module. Preferably, the alignment means is a pair of pins, one of which is spring-mounted. In a further preferred embodiment the alignment means is a pair of protuberances on the module. One of the protuberances may comprise a spring-mounted pin, and a corresponding slot may be provided on the receiver.

In a further preferred embodiment the mounting rails may have a plurality of surface grooves for receipt of said protuberances. Preferably at least one of the protuberances of each module has a bearing and at least one of said surface grooves have a dimple for receipt of said bearing.

In a preferred embodiment the receiver comprises a bottom frame and a top frame, which is pivotally mounted to the bottom frame, the top frame carries the said retaining means and means for receiving an ITA, and the bottom frame carries fixing means to fix it to testing equipment.

Preferably the top frame is demountable from the bottom frame. This has the advantage that the receiver can be separated into two sections in order to allow its easier transportation. This is particularly advantageous if the UUT is in a hard to reach location where it may be necessary to physically carry the testing equipment and the interface connector over rough terrain. Also, allowing the separation of the top and bottom frames allows the receiver to be made larger such that it can be adapted to span two or more pieces of testing equipment at once. The increase in weight which would normally result from this arrangement being alleviated by the fact that it is possible to split the receiver into two separate sections for transportation and/or handling when in-situ.

By way of example only, specific embodiments of the present invention will now be described, with reference to the accompanying drawings, in which:-
- **Fig. 1**: is a front perspective view of a receiver constructed in accordance with the present invention, the back panel of which has been omitted for the sake of clarity, and a perspective view of two receiver connector modules each constructed in accordance with the invention and each of which may be used with this receiver;
- **Fig. 2**: is the similar view to Fig. 1, but from the rear of the receiver;
- **Fig. 3**: is a perspective view of a further embodiment of receiver connector module;
- **Fig. 4**: is a partial front view similar to Fig. 1 illustrating a second embodiment of receiver and of receiver connector module;
- **Fig 5**: is a schematic detail of the receiver connector module and receiver of Fig. 4 illustrating the spring-loaded fixing of the module in the receiver;
- **Fig. 6**: is a view similar to Fig. 4 illustrating a third embodiment of receiver and receiver connector module;
- **Fig. 7**: is a side view of the receiver connector module of Fig. 6;
- **Fig. 8**: is the similar view to Fig. 6 but from the rear;
- **Fig. 9**: is a schematic view of a receiver illustrating the hinged connection of its front panel to its back panel; and
- **Fig 10**: is a view similar to Fig. 9 of an alternative hinge arrangement.

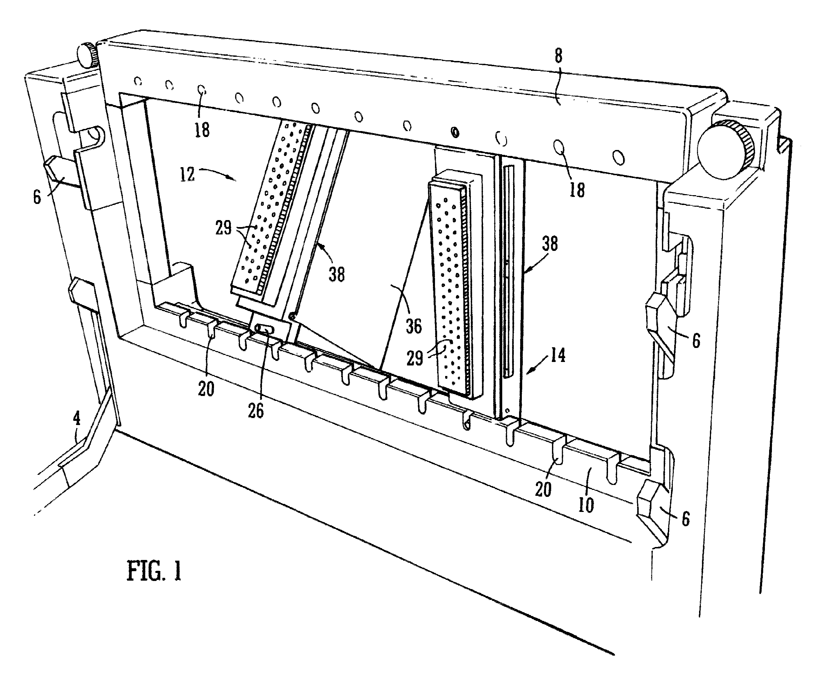

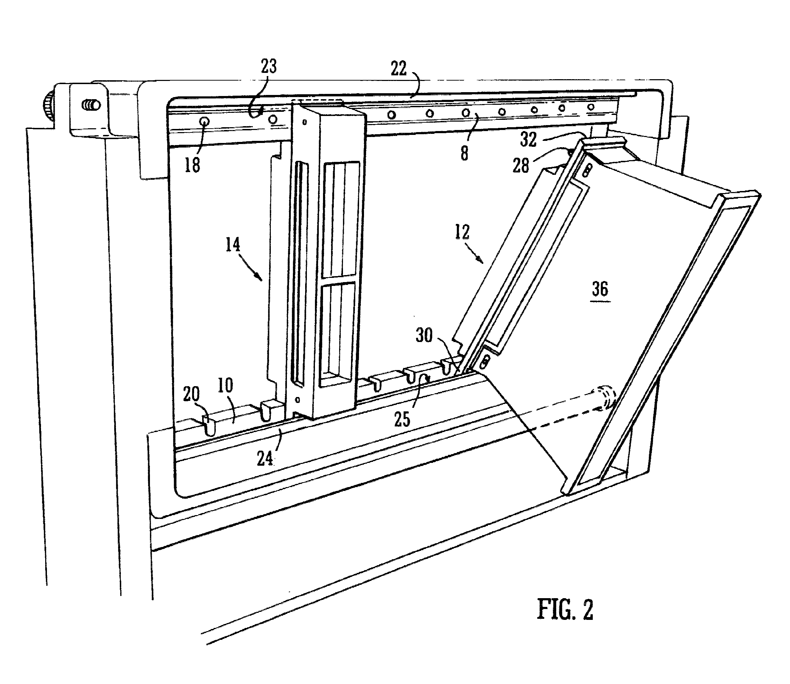

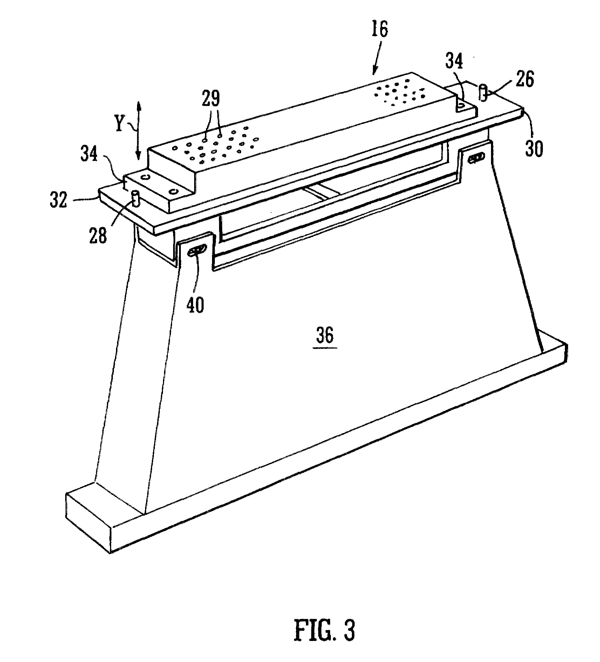

Referring to Figs. 1 and 2 the first embodiment of receiver has a substantially rectangular top panel frame 2 which incorporates a handle 4 operated latch mechanism 6 to receive a ITA (not illustrated). The frame 2 has a pair of mounting bars 8 and 10, between which receiver connector modules 12, 14 and 16 (See Fig. 3) may be mounted. The mounting bar 8 has a series of through apertures 18 and mounting bar 10 has a series of corresponding through slots 20 aligned with the apertures 18. As best illustrated in Fig. 2 the rear of the top panel 2, the rear being the side which faces the bottom panel in use and which bottom panel has been omitted from the figure for the sake of clarity, carries two rails 22 and 24 which together with the mounting bars 8 and 10 form channels 23, 25, the operation of which will be described further hereinunder.

As best illustrated in Fig. 3 each receiver connector modules 12, 14 and 16 carries two alignment pins 26 and 28, one on either side of the section of the module carrying the through bores 29 for receipt of contacts of wiring. Pin 26 is fixed, whilst pin 28 is spring loaded allowing a forced movement along its longitudinal axis Y. Each connector module 12, 14 and 16 also carries two shoulders 30 and 32, shoulder 30 protrudes further beyond the edge 34 of the module than the shoulder 32 does from the opposite edge 34.

The module 12, 14 or 16 is fitted to the receiver as follows:

As best illustrated in Figs. 1 and 2 with respect to module 12, the shoulder 32 is inserted into channel 25 formed between rail 24 and the rear of the mounting bar 10. The shoulder 30 is inserted deeply, down into the channel 25 and its pin 26 into slot 20. The opposite end of the module 12 then rotated towards the top mounting bar 8. The pin 28 is forced to contract into the shoulder 32, when shoulder 32 contacts the rear side of the mounting bar 8. The module 12 is then moved upwards such that shoulder 30 moves upwards within channel 25 and so that shoulder 32 engages in channel 23, as best illustrated with respect to module 14 in Fig. 2. As the module is moved up the pin 28 enters the aperture 18 which is no longer compressed by the bar 8. Entry of the pin into the aperture fixes the relative position of the module on the receiver. The module is retained on the receiver by the rails 22, 24 contacting the rear of shoulders 30, 32 and the mounting bars 8, 10 contacting the front of shoulders 30, 32.

In Figs. 1 to 3 are illustrated three variants of receiver connector module. Each of these modules comprise the same fixing means for fixing the module to the receiver as described above. Modules 12 and 16 are each adapted to be connected to an adapter 36. Module 12 is formed as a unitary unit, whilst module 16 is provided with an anodised aluminium supporting structure on which the pins 26 and 28 are formed. The adapter 36 is to facilitate connection to test cards held in a card cage of a testing unit. The modules 12 and 16 are mounted on the adapter 36 via mounting 40. Mounting 40 facilitates a small amount of predetermined play or relative motion between the module and adapter. This allows a slight repositioning of the connector module when its contacts are mated with those of the ITA connector modules and reduce potential bending of the card, to which the back of the adapter is attached, by correction of any slight misalignment between the contacts held in the receiver and the ITA. This also reduces damage to the contacts. A small amount of play is also present in the slot and apertures of the mounting bars to facilitate this slight play during mating.

The module 14 is not connected to an adapter and although it comprises the anodised aluminium reinforcement as illustrated in the embodiment of Fig. 3, the module 12 which is formed as a unitary piece could also be provided without the adapter, such that the through bores 29 are directly accessible from its rear 38 to allow the insertion of contacts. In this respect modules 12 (minus the adapter) and 14 are particularly suited for use with bench or rack and stack style testing equipment.

In order to remove modules 12, 14 or 16 from the receiver, a blunt pointer is inserted into aperture 18 on mounting bar 8 in order to depress pin 28. The module 12, 14 or 16 can then be moved downward so that shoulder 30 travels more deeply into channel 25, pin 28 moves behind the mounting bar 8 and remains depressed, whilst shoulder 32 is released from channel 23. The now free end of the module can be rotated away from the receiver and the shoulder 30 lifted from channel 25.

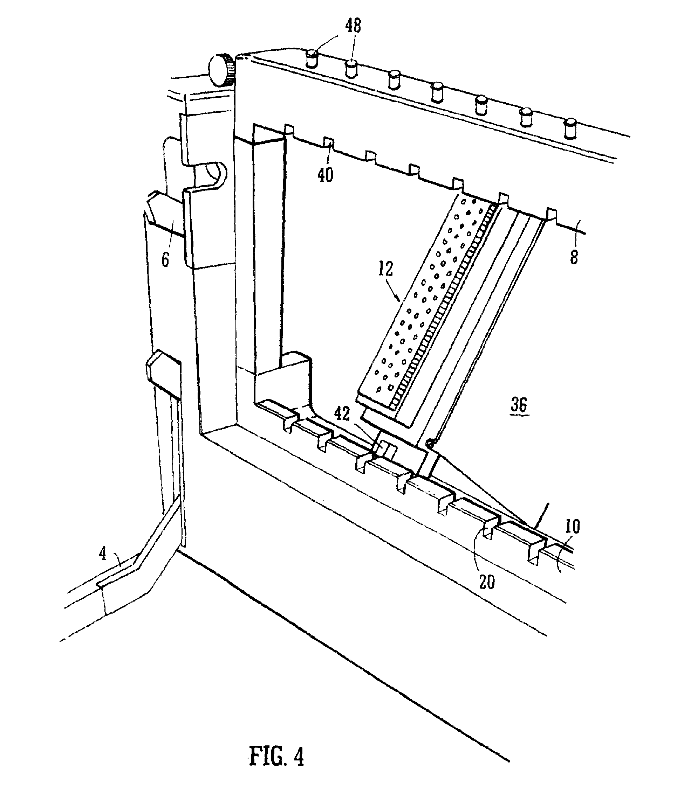

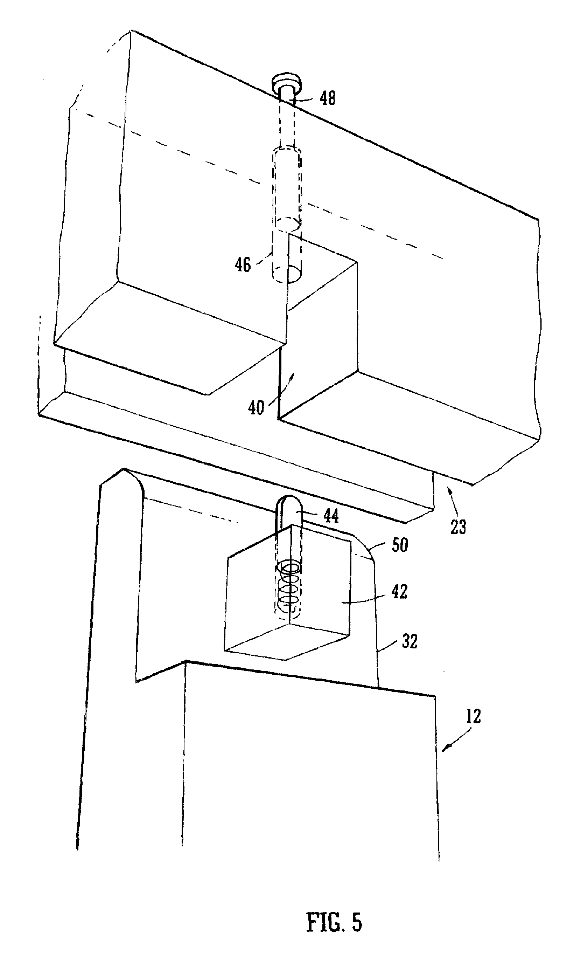

In the embodiments of Figs. 4 and 5 the receiver is modified in that apertures 18 in mounting bar 8 are replaced by a further set of slots 40. The shoulders 30 and 32 of each module 12, 14 and 16 is modified in that each of the pins 26 and 28 are replaced by a protuberance 42. The protuberance 42 on shoulder 30 also includes a spring loaded pin 44 which is biassed out of the protuberance 42. The receiver is further modified to include a pin 44 receiving aperture 46 at the base of slot 40. A plunger 48 is moveably retained in slot 46. The module is inserted into the channels 23 and 25 as per the previous embodiment. However, in this embodiment the protuberances 42 are received in slots 40 and 20 when shoulders 30 and 32 enter channels 25 and 23. The pin 44 at the same time locates in slot 46 to fix the relative position of the module.

In order to release the module, plunger 38 is depressed in order to depress pin 44 against its spring mounting and thereby releasing pin 44 from its fixing in slot 46. Shoulder 30 is then moved down into its channel 25, in order to move shoulder 32 out of its channel 23, allowing the module to be rotated from mounting bar 8 and lifted from channel 25.

The end 50 of shoulders 30 and 32 may be bevelled to allow easier insertion into the channels 25 and 23 and to allow for a slight pivoting when rotating the module upon its mounting within its respective channels.

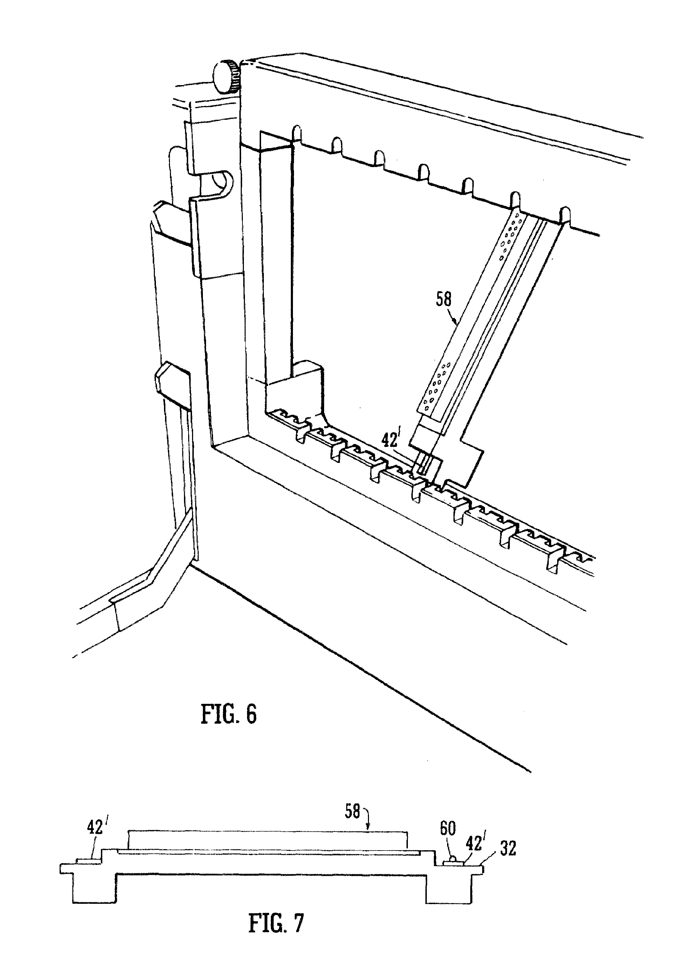

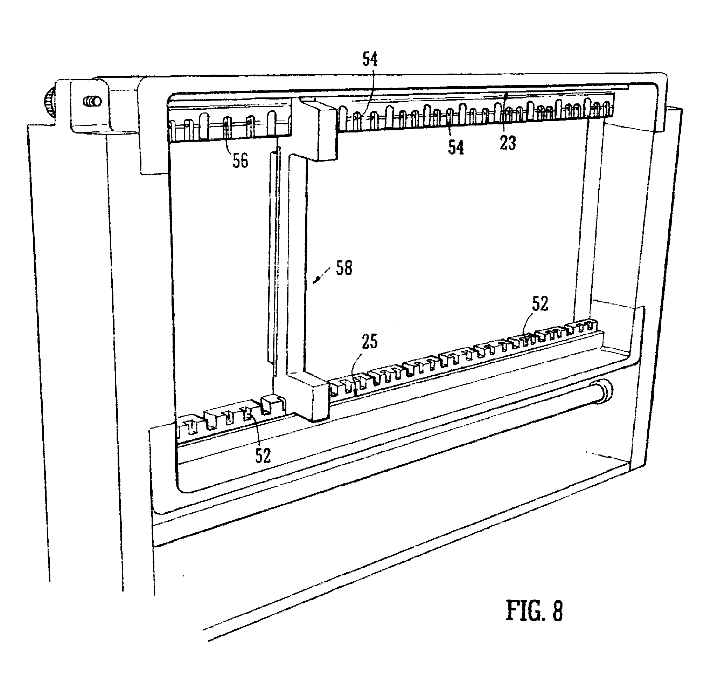

In the embodiment of Figs. 6 to 8, the receiver has been further modified to include a pair of mounting grooves 52 and 54 between each adjacent slot 20 and 40. The mounting grooves 54 on mounting bar 8 also each include a dimple 56. This receiver is adapted to receive and retain receiver connector module 58 which has smaller protuberances 42' on each its shoulders 30 and 32 which are adapted to be received in mounting grooves 52 and 54, when the module is inserted into the channels 25 and 23. The protuberance 42' on shoulder 32 carries a ball bearing 60 which clicks into and is retained in dimple 54 when the protuberance 42' of the module is placed into groove 54. The module 58 is removed by depressing shoulder 30 into channel 25, and thereby forcing ball bearing 60 out of dimple 54. This arrangement of receiver also still receives modules 12, 14 or 16. Therefore a variety of such modules may be fixed to the receiver. The module 58 is thinner than modules 12, 14 and 16 and therefore a greater number of these could be fixed to a single receiver. Although the module 58 has been illustrated as a unitary unit, it could also incorporate the anodised aluminium reinforcement of the type used in module 14 and/or the adapter of module 12 and 16.

The receiver illustrated in Figs. 6 to 8 still retains the slots 20 and 40 for receiving and fixing modules 12, 14 and 16. It is to be understood that the slots 40 may also be replaced by apertures 18.

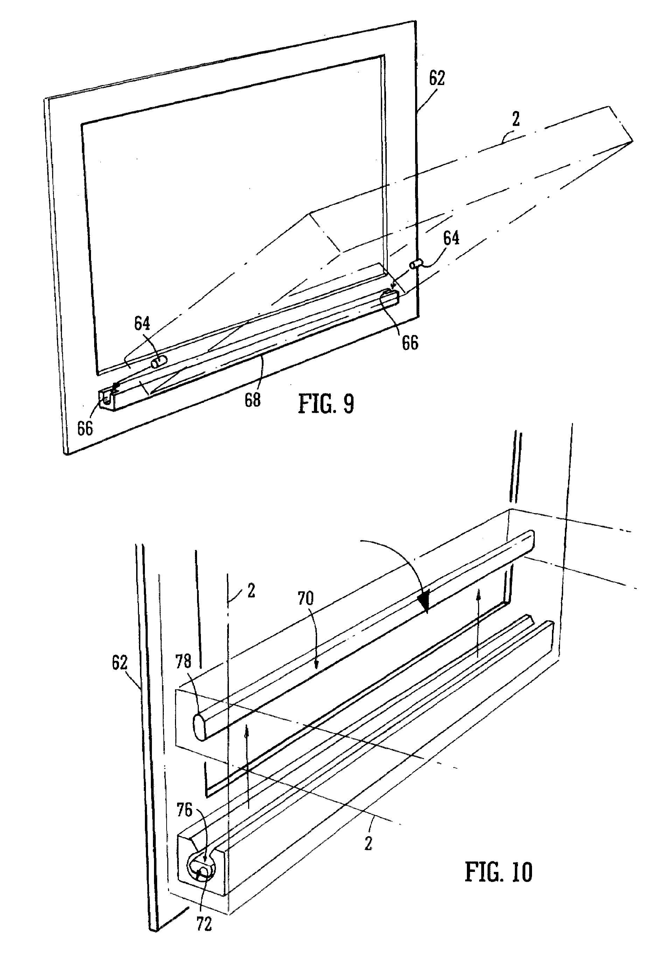

Referring to Fig. 9 the front panel 2 of the receiver in use is mounted on a bottom panel frame 62 which is adapted to be connected to testing equipment such as a card cage containing testing cards. In this instance the bottom panel 62 is adapted to be bolted to the housing of the testing equipment. In order to allow access into such testing equipment and to permit removal of a receiver connector module with adapter, the top panel can be rotated away from the bottom panel 62 to allow the required access. In accordance with the invention the top panel 2 is removable from the bottom panel 62 and for this purpose, the hinge mounting of front panel 2 on bottom panel 62 comprises two inwardly protruding pivots 64 which are releasably retained in corresponding mounting sockets 66 on hinge bracket 68, which is fixed to the bottom panel 62.

In Fig. 10 a further embodiment of the hinge is illustrated in which the two separate pivots are replaced by a single pivot bar 70 which is releasably retained in mounting socket channel 72. Channel 72 replaces the two separate mounting sockets 66 and runs the length of the panel 62. In these two embodiments of hinge the function of the hinge is the same and operates as follows:

The pivots 64, 70 have a substantially oval cross-section, the base of the sockets 66, 72 have a complementary oval configuration. As best illustrated in Fig. 10 when the top panel 2 rests on the bottom panel 62, the configuration in which it is normally used, the oval configurations of the sockets 66, 72 and the pivots 64, 70 are aligned and the sockets 66, 72 cannot pass through socket opening 74. Thereby the top panel 2 is retained on the bottom panel 62. However when the top panel 2 is rotated away from the bottom panel 62, the oval shaped socket 64, 70 rotates within the sockets 66, 72 such that the narrow end 78 of the oval socket 64, 70 can pass through the opening 74 allowing the top panel 2 to be lifted from the bottom panel and thereby separated.

Although the receiver has been described as comprising top and bottom releasably hinged panels, the bottom panel may be omitted.

## Claims

1. A connection interface system for providing an interface between a unit under test and testing equipment, the system comprising a receiver (2) having retaining means (18,20,22,23,24,25,40,52,54) to releasably retain a plurality of receiver connector modules (12,14,16,58) thereon in a reverse mounted position.

2. A system as claimed in claim 1, wherein the retaining means comprises a pair of oppositely disposed channels (23,25) in the body of the receiver (2) which are adapted to receive the modules (12,14,16,58) in a press-fit manner.

3. A system as claimed in claim 2, comprising at least one receiver connector module (12,14,16,58) having mounting means (26,28,30,32,42,42',44,60) arranged for receipt in said channels (23,25) in said press fit manner.

4. A system as claimed in claim 3, wherein the mounting means is a pair of oppositely disposed shoulders (30,32) which stand proud of the module (12,14,16,58).

5. A system as claimed in claim 4, wherein one of the shoulders (30) is longer than the other (32).

6. A system as claimed in claim 4 or 5, wherein at least one of the shoulders (30,32) has a bevelled edge (50).

7. A system as claimed in any one of claims 3 to 6, wherein the mounting means comprises alignment means (26,28,42,42',44,60), and the channels (23,25) have a plurality of corresponding slots (20,40) and/or apertures (18,46) for receipt of said alignment means in order to fix the relative position of the module (12,14,16,58).

8. A system as claimed in claim 6 or 7, wherein the alignment means comprises at least one fixed pin (26).

9. A system as claimed in claim 7 or 8 wherein the alignment means comprises at least one retractable pin (28,44).

10. A system as claimed in claim 9, comprising at least one plunger structured to release the retractable pin from the receiver.

11. A system as claimed in claim 10, wherein the or each plunger (48) is mounted for a reciprocal movement within a respective said channel aperture (46).

12. A system as claimed in any one of claims 7 to 11, wherein the alignment means comprises at least one protrubrance (42) for receipt in a respective slot (20,40).

13. A system as claimed in claim 12, wherein the protrubrance carries a or the retractable pin (44).

14. A system as claimed in any one of claims 3 to 13, wherein the channels (23,25) further comprises surface grooves (52,54) and the mounting means comprises a pair of corresponding oppositely disposed protrubrance (42') for receipt therein.

15. A system as claimed in claim 14, wherein at least one protrubrance (42') of each module has a ball bearing (60), and at least the surface grooves (54) of one channel (23) have a dimple (56) for receipt of the bearing (60).

16. A system as claimed in any one of the preceding claims, wherein the receiver (2) comprises a bottom frame (62) and a top frame (2), which is pivotally mounted to the bottom frame (62), wherein the top frame (2) carries the said retaining means and means for receiving a test adapter, and the bottom frame carries fixing means to fix it to test equipment.

17. A system as claimed in claim 16, wherein the top frame (62) is demountable from the bottom frame (62).

18. A system as claimed in claim 16 or 17, wherein the bottom frame (62) has a hinge bracket (68) and the top frame (62) includes two inwardly protruding pivots (64) which are releasably retained in corresponding mounting sockets (66) on said hinge bracket (68).

19. A system as claimed in claim 16 or 17, wherein the bottom frame has a hinge bracket (68) having a mounting socket channel (72), and the top frame has a pivot bar (70) that is releasably retained in said mounting socket channel (72).

20. A system as claimed in claim 18, wherein the or each pivot (64,70) has a substantially oval cross-section and the or each of the mounting sockets (66,72) has a complimentary oval cross section.

21. A system as claimed in claim 18 or 19 wherein the or each pivot (64,70) has a cross-sectional profile including a major dimension and a minor dimension and the mounting socket (66,72) has an opening to accommodate the minor dimension but not the major dimension to enable mounting of the top frame (2) to the bottom frame (62), whereby the major dimension of the pivot (64,70) prohibits release of the top frame (2) during testing of the unit under test.

22. A connection interface system for providing an interface between a unit under test and testing equipment, the system comprising a receiver connector module (12,14,16,58) having a pair of oppositely disposed shoulders (30,32) for releasable receipt in retaining channels (23,25) of a receiver (2).
